# EUROPEAN PATENT APPLICATION

(11) **EP 4 552 788 A1**
(43) Date of publication of application: **14.05.2025**
(21) Application number: 23857332.3
(22) Date of filing: 22.08.2023
(51) Int. Cl.: B23K 35/363, B23K 35/26, C22C 13/00, H01L 23/373

(54) **FLUX AND METHOD FOR PRODUCING BONDED OBJECT**

(30) Priority: 26.08.2022 JP 2022135185
(71) Applicant: Senju Metal Industry Co., Ltd., Tokyo 120-8555 (JP)
(72) Inventor: KAWANAGO, Tomohisa, Tokyo 120-8555 (JP); KAJIKAWA, Yasuhiro, Tokyo 120-8555 (JP)
(74) Representative: Lavoix
(86) International application number: PCT/JP2023/030091
(87) International publication number: WO 2024/043223

(57) **Abstract**

A flux can be suitably used for implementing an indium sheet and has high wettability and a high ability to suppress generation of voids even in a case where bonding is performed at a relatively low temperature. A flux containing a rosin, an organic acid, and a solvent (S) is employed. The organic acid includes a monocarboxylic acid (A1) having a melting point of 35°C or higher and 90°C or lower, and the solvent (S) includes a solvent (S1) having a boiling point of 100°C or lower.

## Description

### TECHNICAL FIELD

The present invention relates to a flux and a method for producing a bonded object. Priority is claimed on Japanese Patent Application No. 2022-135185, filed August 26, 2022, the content of which is incorporated herein by reference.

### BACKGROUND ART

In recent years, electronic devices have been required to have a large capacity and a high speed. A highly integrated die installed in such an electronic device generates a large amount of heat during an operation.

Therefore, it is necessary to efficiently discharge the generated heat by mounting a lid or the like, which is provided with a heat sink, on the die.

Under such circumstances, for example, Patent Document 1 suggests that a thermal interface material (TIM) containing a polymer is sandwiched between a die and a lid provided with a heat sink in order to transmit heat generated by the operation of the die to the heat sink with higher efficiency.

### Citation List

### Patent Document

Patent Document 1: Published Japanese Translation No. 2010-539706 of the PCT International Publication

### SUMMARY OF INVENTION

### Technical Problem

A sheet (hereinafter, referred to as an indium sheet) formed of only indium has been suggested as the TIM. Indium has a hardness lower than the hardness of other metal elements, and the indium sheet has high followability and high adhesiveness with respect to the surfaces of a die and a lid. Therefore, the indium sheet has high heat transfer efficiency from the die to the lid provided with a heat sink. As a result, it is possible to increase the heat discharge efficiency due to the operation of the die by using the indium sheet.

**In** implementation of the indium sheet, a lid provided with a heat sink and a die are bonded by using an indium sheet having a surface coated with the flux. Since indium has a relatively low melting point of 156°C, the bonding of the indium sheet by a reflow method is performed under a low temperature condition as compared with typical bonding.

For example, in a case where the indium sheet is implemented under a condition of 170°C using a flux for soldering in the related art, the flux does not wet-spread on the surface of the indium sheet and is accumulated on the bonding surface, and as a result, a large number of voids are generated on the bonding surface in some cases. Due to the voids, the heat transfer efficiency from the die to the lid provided with the heat sink via the indium sheet is reduced, and the heat discharge efficiency due to the operation of the die is reduced.

Therefore, an object of the present invention is to provide a flux that can be suitably used for implementing an indium sheet and that has high wettability and an enhanced ability to suppress generation of voids even in a case of performing bonding under a relatively low temperature condition.

### Solution to Problem

The present invention includes the following aspects.
[1] A flux including: a rosin; an organic acid; and a solvent (S), in which the organic acid includes a monocarboxylic acid (A1) having a melting point of 35°C or higher and 90°C or lower, and the solvent (S) includes a solvent (S1) having a boiling point of 100°C or lower.
[2] The flux according to [1], in which the monocarboxylic acid (A1) has a molecular weight of 180 or greater and 350 or less.
[3] The flux according to [1] or [2], in which a content of the solvent (S1) is 50% by mass or greater with respect to a total mass of the solvent (S).
[4] The flux according to any one of [1] to [3], further including: an alkanolamine.
[5] The flux according to any one of [1] to [4], in which a content of the monocarboxylic acid (A1) is 0.5% by mass or greater and 20% by mass or less with respect to a total mass of the flux.
[6] The flux according to any one of [1] to [5], in which the monocarboxylic acid (A1) includes palmitic acid, and a content of the palmitic acid is 60% by mass or greater with respect to a total mass of the monocarboxylic acid (A1).
[7] The flux according to any one of [1] to [6], in which a content of the rosin is 10% by mass or greater and 50% by mass or less with respect to a total mass of the flux.
[8] A method for producing a bonded object in which a die and a lid are bonded to each other through a thermal interface material (TIM), in which the TIM is an indium sheet, and the bonding is performed by a reflow method with the flux according to any one of [1] to [7] being sandwiched between at least one of the TIM and the die or the TIM and the lid.
[9] The method for producing a bonded object according to [8], in which the bonding is performed by the reflow method at a temperature of lower than 200°C. Advantageous Effects of Invention

According to the present invention, it is possible to provide a flux that can be suitably used for implementing an indium sheet and that has high wettability and an enhanced ability to suppress generation of voids even in a case of performing bonding under a relatively low temperature condition.

### BRIEF DESCRIPTION OF DRAWINGS

[FIG. 1] A cross-sectional view showing a lid, a TIM, and a die according to one embodiment of a method for producing a bonded object.
[FIG. 2] A cross-sectional view showing a step of coating the TIM and the die with a flux according to the embodiment of the method for producing a bonded object.
[FIG. 3] A cross-sectional view showing a bonded object obtained by fixing the lid to a substrate using the TIM after application of the flux according to the embodiment of the method for producing a bonded object.

### DESCRIPTION OF EMBODIMENTS

### (Flux)

A flux according to the present embodiment contains a rosin, an organic acid, and a solvent (S). The organic acid includes a monocarboxylic acid (A1) having a melting point of 35°C or higher and 90°C or lower. The solvent (S) includes a solvent (S1) having a boiling point of 100°C or lower.

In implementation of an indium sheet, a lid provided with a heat sink and a die are bonded with an indium sheet by performing reflow under a low temperature condition (for example, 170°C). **In** a flux of the related art, the flux does not wet-spread on the surface of the indium sheet and is accumulated on the bonding surface, and as a result, a large number of voids are generated on the bonding surface in some cases.

Since the flux according to the present embodiment contains the monocarboxylic acid (A1) having a melting point of 35°C or higher and 90°C or lower, even in a case where reflow is performed at a low temperature, the monocarboxylic acid (A1) is melted to such an extent that gas is easily released, and thus the wettability with respect to the indium sheet can be sufficiently obtained.

Since the reactivity of the monocarboxylic acid (A1) contained in the flux according to the present embodiment is lower than the reactivity of the dicarboxylic acid, the generation of voids is likely to be suppressed.

In addition, the solvent (S1) having a boiling point of 100°C or lower, which is contained in the flux according to the present embodiment, is volatilized before the indium sheet is melted even in a case where reflow is performed at a low temperature. As a result, voids derived from the solvent (S1) are not generated in a case where indium is melted.

Due to these synergistic effects, the flux according to the present embodiment can suppress the generation of voids even in the implementation of the indium sheet.

### <Rosin>

In the present invention, the term "rosin" includes natural resins containing a mixture of abietic acid and its isomer with abietic acid as a main component, and resins (may be referred to as rosin derivatives) which are obtained by chemically modifying natural resins.

The total content of the abietic acid and the isomer of the abietic acid in the natural resin is, for example, 40% by mass or greater and 80% by mass or less with respect to the natural resin.

In the present specification, the term "main component" denotes a component contained in a compound by an amount of 40% by mass or greater in the components constituting the compound.

Examples of typical isomers of abietic acid include neoabietic acid, palustric acid, and levopimaric acid. The structure of abietic acid is shown below.

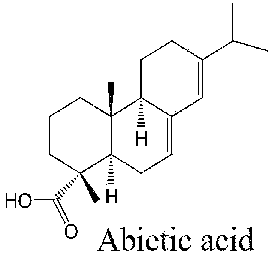

As the above-described "natural resin" a gum rosin, a wood rosin, and a tall oil rosin are exemplary examples.

In the present invention, "substance (rosin derivative) obtained by chemically modifying a natural resin" includes a substance obtained by performing one or more treatments selected from the group consisting of hydrogenation, dehydrogenation, neutralization, alkylene oxide addition, amidation, dimerization, multimerization, esterification, and Diels-Alder cycloaddition on "natural resin".

Examples of the rosin derivatives include a purified rosin and a modified rosin.

Examples of the modified rosin include a hydrogenated rosin, a polymerized rosin, a polymerized hydrogenated rosin, a disproportionated rosin, an acid-modified rosin, a rosin ester, an acid-modified hydrogenated rosin, an acid anhydride-modified hydrogenated rosin, an acid-modified disproportionated rosin, an acid anhydride-modified disproportionated rosin, a phenol-modified rosin, an α,β unsaturated carboxylic acid-modified product (such as an acrylic acid-modified rosin, a maleic acid-modified rosin, and a fumaric acid-modified rosin), purified products, hydrides, and disproportionated products of the polymerized rosin, purified products, hydrides, and disproportionated products of the α,β unsaturated carboxylic acid-modified product, a rosin alcohol, a rosin amine, a hydrogenated rosin alcohol, a rosin ester, a hydrogenated rosin ester, a rosin soap, a hydrogenated rosin soap, and an acid-modified rosin soap.

The rosin amine is, for example, a mixture of dehydroabietylamine, dihydroabietylamine, and tetrahydroabietylamine, and denotes a so-called disproportionated rosin amine. The structures of each of dehydroabietylamine, dihydroabietylamine, and tetrahydroabietylamine are shown below.

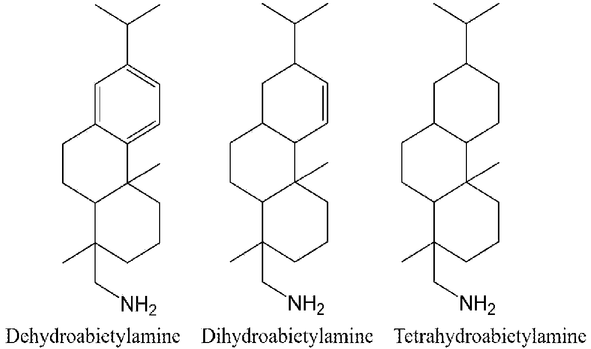

The rosin may be used alone or in the form of a mixture of two or more kinds thereof.

The rosin includes preferably a rosin derivative and more preferably one or more selected from the group consisting of an acid-modified hydrogenated rosin and a hydrogenated rosin.

The content of the rosin in the flux is preferably 5% by mass or greater and 70% by mass or less, more preferably 10% by mass or greater and 50% by mass or less, and still more preferably 15% by mass or greater and 45% by mass or less with respect to the total mass (100% by mass) of the flux.

In a case where the content of the rosin is the lower limits or greater of the above-described ranges, the wettability of the flux is likely to be increased, and the generation of voids is likely to be suppressed. In a case where the content of the rosin is the upper limits or less of the above-described ranges, the generation of voids is likely to be suppressed.

### <Organic acid>

The organic acid contained in the flux according to the present embodiment includes a monocarboxylic acid (A1) having a melting point of 35°C or higher and 90°C or lower. The organic acid contained in the flux according to the present embodiment may include other organic acids in addition to the monocarboxylic acid (A1).

### <<Monocarboxylic acid (A1)>>

The monocarboxylic acid (A1) has a melting point of 35°C or higher and 90°C or lower. The monocarboxylic acid denotes a carboxylic acid having one carboxy group in a molecule.

The melting point of the monocarboxylic acid (A1) is preferably 40°C or higher and 85°C or lower, more preferably 45°C or higher and 80°C or lower, still more preferably 50°C or higher and 72°C or lower, particularly preferably 55°C or higher and 66°C or lower, and most preferably 60°C or higher and 66°C or lower.

Since the melting point of indium is a low temperature of 156°C, the implementation of the indium sheet is performed by low-temperature reflow (for example, 170°C).

In a case where the melting point of the monocarboxylic acid (A1) is the lower limits or greater of the above-described ranges, the reaction between the indium sheet and the monocarboxylic acid (A1) during the reflow is likely to be suppressed, and thus the generation of voids during the reflow is likely to be suppressed.

In a case where the melting point of the monocarboxylic acid (A1) is the upper limits or lower of the above-described ranges, the monocarboxylic acid (A1) in the flux is likely to be melted during the reflow, and thus voids to be generated during the reflow are likely to be removed from the flux. In addition, the wettability of the flux is likely to be increased.

The molecular weight of the monocarboxylic acid (A1) is preferably 180 or greater and 350 or less, more preferably 190 or greater and 310 or less, still more preferably 220 or greater and 275 or less, particularly preferably 240 or greater and 265 or less, and most preferably 250 or greater and 260 or less.

In a case where the molecular weight of the monocarboxylic acid (A1) is the lower limits or greater of the above-described ranges, the molar amount of the monocarboxylic acid (A1) contained in the flux at the same content (% by mass) is further decreased, and thus the generation of voids during the reflow is likely to be suppressed.

In a case where the molecular weight of the monocarboxylic acid (A1) is the upper limits or less of the above-described ranges, the molar amount of the monocarboxylic acid (A1) contained in the flux at the same content (% by mass) is increased, and thus the wettability of the flux is likely to be increased.

Examples of the monocarboxylic acid (A1) include an aliphatic monocarboxylic acid and an aromatic monocarboxylic acid. Among these, an aliphatic monocarboxylic acid is preferable.

The aliphatic monocarboxylic acid may or may not contain a hydroxy group.

The hydrocarbon group of the aliphatic monocarboxylic acid may be any of linear, branched, or cyclic. The hydrocarbon group is preferably linear or branched and more preferably linear.

The above-described hydrocarbon group may be a saturated hydrocarbon group or an unsaturated hydrocarbon group. The hydrocarbon group is preferably a saturated hydrocarbon group.

The number of carbon atoms in the aliphatic monocarboxylic acid is preferably in a range of 12 to 24, more preferably in a range of 12 to 18, still more preferably in a range of 14 to 17, particularly preferably in a range of 15 to 17, and most preferably 16.

In a case where the monocarboxylic acid (A1) is a linear aliphatic monocarboxylic acid, examples of the monocarboxylic acid (A1) include lauric acid (C12, 45°C, 200), tridecanoic acid (C13, 41°C, 214), myristic acid (C14, 54°C, 228), pentadecanoic acid (C15, 52°C, 242), palmitic acid (C16, 63°C, 256), margaric acid (C17, 61°C, 270), stearic acid (C18, 70°C, 284), nonadecylic acid (C19, 69°C, 299), arachidic acid (C20, 76°C, 313), heneicosylic acid (C21, 75°C, 327), behenic acid (C22, 76°C, 341), tricosylic acid (C23, 80°C, 355), and lignoceric acid (C24, 84°C, 369). The description in the parentheses denotes the number of carbon atoms, the melting point, and the molecular weight.

In a case where the monocarboxylic acid (A1) is a linear aliphatic monocarboxylic acid, among examples, the monocarboxylic acid (A1) is preferably one or more selected from the group consisting of lauric acid, tridecanoic acid, myristic acid, pentadecanoic acid, palmitic acid, margaric acid, and stearic acid, more preferably one or more selected from the group consisting of myristic acid, pentadecanoic acid, palmitic acid, margaric acid, and stearic acid, still more preferably one or more selected from the group consisting of palmitic acid and stearic acid, and particularly preferably palmitic acid.

In a case where the monocarboxylic acid (A1) is an aliphatic monocarboxylic acid containing a hydroxy group, 12-hydroxystearic acid is preferable as the monocarboxylic acid (A1). The 12-hydroxystearic acid has a melting point of 76.5°C, a molecular weight of 300, and 18 carbon atoms.

The monocarboxylic acid (A1) may be used alone or in the form of a mixture of two or more kinds thereof.

The content of the monocarboxylic acid (A1) is preferably 0.1% by mass or greater and 30% by mass or less, more preferably 0.5% by mass or greater and 20% by mass or less, still more preferably 1% by mass or greater and 20% by mass or less, particularly preferably 1% by mass or greater and 15% by mass or less, and most preferably 3% by mass or greater and 15% by mass or less with respect to the total amount (100% by mass) of the flux.

In a case where the content of the monocarboxylic acid (A1) is the lower limits or greater of the above-described ranges, the wettability of the flux is likely to be improved, and the generation of voids is likely to be suppressed. In a case where the content of the monocarboxylic acid (A1) is the upper limits or less of the above-described ranges, the generation of voids is likely to be suppressed.

The content of the palmitic acid is preferably 60% by mass or greater and 100% by mass or less with respect to the total mass of the monocarboxylic acid (A1).

In a case where the content of palmitic acid is the lower limits or greater of the above-described ranges, the ability to suppress generation of voids is likely to be enhanced.

### <<Other organic acids>>

Examples of the organic acid include a carboxylic acid and an organic sulfonic acid. Examples of the carboxylic acid include an aliphatic carboxylic acid and an aromatic carboxylic acid. Examples of the aliphatic carboxylic acid include an aliphatic monocarboxylic acid and an aliphatic dicarboxylic acid other than the monocarboxylic acid (A1).

Examples of the aliphatic monocarboxylic acid include caproic acid, enanthic acid, caprylic acid, pelargonic acid, isopelargonic acid, capric acid, caproleic acid, undecanoic acid, linderic acid, myristoleic acid, isopalmitic acid, palmitoleic acid, hiragonic acid, hydnocarpic acid, isostearic acid, elaidic acid, petroselinic acid, moroctic acid, eleostearic acid, terephthalic acid, vaccenic acid, ricinoleic acid, vernolic acid, sterculic acid, oleic acid, linoleic acid, and linolenic acid.

Examples of the aliphatic dicarboxylic acid include oxalic acid, malonic acid, succinic acid, glutaric acid, adipic acid, pimelic acid, suberic acid, azelaic acid, sebacic acid, dodecanedioic acid, eicosanedioic acid, tartaric acid, 2,4-diethylglutaric acid, diglycolic acid, 2-methylnonanedioic acid, 4-(methoxycarbonyl)-2,4-dimethylundecanedioic acid, 4,6-bis(methoxycarbonyl)-2,4,6-trimethyltridecanedioic acid, and 8,9-bis(methoxycarbonyl)-8,9-dimethylhexadecanedioic acid.

Examples of the aromatic carboxylic acid include salicylic acid, dibutyl aniline diglycolic acid, terephthalic acid, parahydroxy phenyl acetic acid, phenyl succinic acid, phthalic acid, benzoic acid, 2,3-dihydroxybenzoic acid, 2-quinoline carboxylic acid, 3-hydroxybenzoic acid, p-anisic acid, picolinic acid, dipicolinic acid, and 3-hydroxypicolinic acid.

In addition, examples of the carboxylic acid include tris(2-carboxyethyl) isocyanurate, and 1,3-cyclohexanedicarboxylic acid.

In addition, examples of the other organic acids include hydroxycarboxylic acid.

Examples of the hydroxycarboxylic acid include 2,2-bis(hydroxymethyl)propionic acid, 2,2-bis(hydroxymethyl)butanoic acid, citric acid, isocitric acid, malic acid, and tartaric acid.

In addition, examples of the other organic acids include a dimer acid, a trimer acid, a hydrogenated dimer acid which is a hydrogenated product obtained by adding hydrogen to a dimer acid, and a hydrogenated trimer acid which is a hydrogenated product obtained by adding hydrogen to a trimer acid.

Examples of the organic sulfonic acid include an aliphatic sulfonic acid, and an aromatic sulfonic acid. Examples of the aliphatic sulfonic acid include an alkanesulfonic acid and an alkanolsulfonic acid.

The flux according to the present embodiment may or may not contain other organic acids.

The other organic acids may be used alone or in the form of a mixture of two or more kinds thereof.

In a case where the flux according to the present embodiment contains other organic acids, the content of the other organic acids may be greater than 0% by mass and 10% by mass or less, greater than 0% by mass and 7% by mass or less, greater than 0% by mass and 5% by mass or less, greater than 0% by mass and 3% by mass or less, greater than 0% by mass and 2% by mass or less, greater than 0% by mass and 1% by mass or less, greater than 0% by mass and 0.5% by mass or less, greater than 0% by mass and 0.3% by mass or less, or greater than 0% by mass and 0.1% by mass with respect to the total amount (100% by mass) of the flux.

### <Solvent (S)>

The solvent (S) includes a solvent (S1) having a boiling point of 100°C or lower. Examples of the solvent (S1) include 2-propanol and ethanol.

The solvent (S1) may be used alone or in the form of a mixture of two or more kinds thereof.

The boiling point of the solvent (S1) is preferably 50°C or higher and 100°C or lower, more preferably 60°C or higher and 90°C or lower, and still more preferably 70°C or higher and 85°C or lower.

In the present specification, the boiling point denotes a temperature of a liquid in a case where a saturated vapor pressure of a target liquid is equal to 1 atm (that is, 1013 hPa).

The solvent (S) may contain other solvents (S2) in addition to the solvent (S1).

The solvent (S2) may be used alone or in the form of a mixture of two or more kinds thereof.

The boiling point of the other solvents (S2) is higher than 100°C. The boiling point of the other solvents (S2) is preferably higher than 100°C and 350°C or lower, more preferably 150°C or higher and 300°C or lower, and still more preferably 200°C or higher and 280°C or lower.

Examples of the other solvents (S2) include an alcohol-based solvent, a glycol ether-based solvent, and terpineols.

Examples of the alcohol-based solvent include 1,2-butanediol, 1,3-butanediol, 1,4-butanediol, 2,3-butanediol, isobornylcyclohexanol, 2,4-diethyl-1,5-pentanediol, 2,2-dimethyl-1,3-propanediol, 2,5-dimethyl-2,5-hexanediol, 2,5-dimethyl-3-hexyne-2,5-diol, 2,3-dimethyl-2,3-butanediol, 2-methylpentane-2,4-diol, 1,1,1-tris(hydroxymethyl)propane, 2-ethyl-2-hydroxymethyl-1,3-propanediol, 2,2'-oxybis(methylene)bis(2-ethyl-1,3-propanediol), 2,2-bis(hydroxymethyl)-1,3-propanediol, 1,2,6-trihydroxyhexane, 1-ethynyl-1-cyclohexanol, 1,4-cyclohexanediol, 1,4-cyclohexanedimethanol, 2,4,7,9-tetramethyl-5-decyne-4,7-diol, 2-hexyl-1-decanol, 2-methyl-2,4-pentanediol (hexylene glycol), and octanediol.

Examples of the glycol ether-based solvent include diethylene glycol mono-2-ethylhexyl ether, ethylene glycol monophenyl ether, ethylene glycol monobutyl ether (butyl glycol), ethylene glycol monohexyl ether (hexyl glycol), diethylene glycol monohexyl ether (hexyl diglycol), diethylene glycol dibutyl ether, triethylene glycol monobutyl ether, methyl propylene triglycol, triethylene glycol butyl methyl ether, tetraethylene glycol, tetraethylene glycol dimethyl ether, and tripropylene glycol-n-butyl ether.

Examples of the terpineols include α-terpineol, β-terpineol, γ-terpineol, and a terpineol mixture (that is, a mixture containing α-terpineol as a main component and β-terpineol or γ-terpineol).

Examples of other solvents include dioctyl sebacate (DOS) and liquid paraffin.

The other solvents may be used alone or in combination of two or more kinds thereof.

The total content of the solvent (S) in the flux is preferably 10% by mass or greater and 95% by mass or less and more preferably 25% by mass or greater and 90% by mass or less with respect to the total amount (100% by mass) of the flux.

The content of the solvent (S1) in the above-described flux is preferably 10% by mass or greater and 95% by mass or less, more preferably 25% by mass or greater and 90% by mass or less, and still more preferably 29.5% by mass or greater and 88.5% by mass or less with respect to the total amount (100% by mass) of the flux.

The content of the solvent (S1) is preferably 50% by mass or greater and 100% by mass or less, more preferably 55% by mass or greater and 100% by mass or less, still more preferably 60% by mass or greater and 100% by mass or less, particularly preferably 65% by mass or greater and 100% by mass or less, and may be 70% by mass or greater and 100% by mass or less, 80% by mass or greater and 100% by mass or less, 90% by mass or greater and 100% by mass or less, 95% by mass or greater and 100% by mass or less, or 100% by mass with respect to the total mass of the solvent (S).

In a case where the content of the solvent (S1) is the lower limits or greater of the above-described ranges, the ability to suppress generation of voids is likely to be enhanced. In addition, spray-coating of the flux is easily performed.

### <Other components>

The flux according to the present embodiment may contain other components in addition to the rosin, the organic acid, and the solvent (S), as necessary.

Examples of the other components include resin components other than the rosin, an activator other than the organic acid, a thixotropic agent, a metal inactivator, a surfactant, a silane coupling agent, an antioxidant, and a colorant.

### <<Resin component other than rosin>>

Examples of the resin other than the rosin include a terpene resin, a modified terpene resin, a terpene phenol resin, a modified terpene phenol resin, a styrene resin, a modified styrene resin, a xylene resin, a modified xylene resin, an acrylic resin, a polyethylene resin, an acrylic-polyethylene copolymer resin, an ethylene-vinyl acetate copolymer resin, and other thermosetting resins.

As the modified terpene resin, an aromatic modified terpene resin, a hydrogenated terpene resin, and a hydrogenated aromatic modified terpene resin are exemplary examples. Examples of the modified terpene phenol resin include a hydrogenated terpene phenol resin. Examples of the modified styrene resin include a styrene acrylic resin and a styrene maleic acid resin. Examples of the modified xylene resin include a phenol-modified xylene resin, an alkylphenol-modified xylene resin, a phenol-modified resol-type xylene resin, a polyol-modified xylene resin, and a polyoxyethylene-added xylene resin.

Examples of the other thermosetting resins include an epoxy resin.

Examples of the epoxy resin include a bisphenol A type epoxy resin, a bisphenol F type epoxy resin, a bisphenol S type epoxy resin, a glycidylamine type resin, an alicyclic epoxy resin, an aminopropane type epoxy resin, a biphenyl type epoxy resin, a naphthalene type epoxy resin, an anthracene type epoxy resin, a triazine type epoxy resin, a dicyclopentadiene type epoxy resin, a triphenylmethane type epoxy resin, a fluorene type epoxy resin, a phenol aralkyl type epoxy resin, and a novolac type epoxy resin.

The flux according to the present embodiment may contain no resin component other than the rosin.

In a case where the flux according to the present embodiment contains a resin component other than the rosin, the content of the resin component other than the rosin may be greater than 0% by mass and 10% by mass or less, greater than 0% by mass and 7% by mass or less, greater than 0% by mass and 5% by mass or less, greater than 0% by mass and 3% by mass or less, greater than 0% by mass and 2% by mass or less, greater than 0% by mass and 1% by mass or less, greater than 0% by mass and 0.5% by mass or less, greater than 0% by mass and 0.3% by mass or less, or greater than 0% by mass and 0.1% by mass or less with respect to the total amount (100% by mass) of the flux.

### <<Activator other than organic acid>>

Examples of the activator other than the organic acid include an amine, a halogen compound, and an organic phosphorus compound.

### [Amine]

Examples of the amine include azoles, guanidines, alkanolamines, alkylamine compounds, and amine-polyoxyalkylene adducts.

Examples of the azoles include 2-methylimidazole, 2-ethylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, 2-phenylimidazoline, 2,4-diamino-6-vinyl-s-triazine, a 2,4-diamino-6-vinyl-s-triazine isocyanuric acid adduct, 2,4-diamino-6-methacryloyloxyethyl-s-triazine, an epoxy-imidazole adduct, 2-methylbenzimidazole, 2-octylbenzimidazole, 2-pentylbenzimidazole, 2-(1-ethylpentyl)benzimidazole, 2-nonylbenzimidazole, 2-(4-thiazolyl)benzimidazole, benzimidazole, 1,2,4-triazole, 2-(2'-hydroxy-5'-methylphenyl)benzotriazole, 2-(2'-hydroxy-3'-tert-butyl-5'-methylphenyl)-5-chlorobenzotriazole, 2-(2'-hydroxy-3',5'-di-tert-amylphenyl)benzotriazole, 2-(2'-hydroxy-5'-tert-octylphenyl)benzotriazole, 2,2'-methylenebis[6-(2H-benzotriazol-2-yl)-4-tert-octylphenol], 6-(2-benzotriazolyl)-4-tert-octyl-6'-tert-butyl-4'-methyl-2,2'-methylenebisphenol, 1,2,3-benzotriazole, 1-[N,N-bis(2-ethylhexyl)aminomethyl]benzotriazole, carboxybenzotriazole, 1-[N,N-bis(2-ethylhexyl)aminomethyl]methylbenzotriazole, 2,2'-[[(methyl-1H-benzotriazol-1-yl)methyl]imino]bisethanol, 1-(1',2'-dicarboxyethyl)benzotriazole, 1-(2,3-dicarboxypropyl)benzotriazole, 1-[(2-ethylhexylamino)methyl]benzotriazole, 2,6-bis[(1H-benzotriazol-1-yl)methyl]-4-methylphenol, 5-methylbenzotriazole, and 5-phenyltetrazole.

Examples of the guanidines include 1,3-diphenylguanidine, 1,3-di-o-tolylguanidine, 1-o-tolylbiguanide, 1,3-di-o-cumenylguanidine, and 1,3-di-o-cumenyl-2-propionylguanidine.

Examples of the alkanolamine include N,N,N',N'-tetrakis(2-hydroxypropyl)ethylenediamine, N,N,N',N'-tetrakis(2-hydroxyethyl)ethylenediamine, monoethanolamine, diethanolamine, triethanolamine, 1-amino-2-propanol, bis(2-hydroxypropyl)amine, and tris(2-hydroxypropyl)amine.

Examples of the alkylamine compound include ethylamine, triethylamine, ethylenediamine, triethylenetetramine, cyclohexylamine, hexadecylamine, and stearylamine.

Examples of the amine-polyoxyalkylene adducts include diamine-terminated polyalkylene glycols, aliphatic amine-polyoxyalkylene adducts, aromatic amine-polyoxyalkylene adducts, and polyvalent amine-polyoxyalkylene adducts.

Examples of alkylene oxides added to the amine-polyoxyalkylene adducts include ethylene oxides, propylene oxides, and butylene oxides.

The diamine-terminated polyalkylene glycol is a compound in which both terminals of polyalkylene glycol are aminated.

Examples of the diamine-terminated polyalkylene glycols include diamine-terminated polyethylene glycols, diamine-terminated polypropylene glycols, and diamine-terminated polyethylene glycol-polypropylene glycol copolymers.

Examples of the diamine-terminated polyethylene glycol-polypropylene glycol copolymers include a bis(2-aminopropyl) ether polyethylene glycol-polypropylene glycol copolymer and a bis(2-aminoethyl) ether polyethylene glycol-polypropylene glycol copolymer.

The aliphatic amine-polyoxyalkylene adducts, the aromatic amine-polyoxyalkylene adducts, and the polyvalent amine-polyoxyalkylene adducts are those in which polyoxyalkylene groups are bonded to the nitrogen atoms of amines. Examples of the amines include ethylenediamine, 1,3-propanediamine, 1,4-butanediamine, hexamethylenediamine, diethylenetriamine, laurylamine, stearylamine, oleylamine, beef tallow amine, cured beef tallow amine, beef tallow propyldiamine, meta-xylenediamine, tolylenediamine, para-xylenediamine, phenylenediamine, isophoronediamine, 1,10-decanediamine, 1,12-dodecanediamine, 4,4-diaminodicyclohexylmethane, 4,4-diaminodiphenylmethane, butane-1,1,4,4-tetramine, and pyrimidine-2,4,5,6-tetramine.

The amine may be used alone or in the form of a mixture of two or more kinds thereof.

As the amine, an alkanolamine is preferable, one or more selected from the group consisting of monoethanolamine, diethanolamine, triethanolamine, and 1-amino-2-propanol are more preferable, and diethanolamine is still more preferable.

The content of the amine is preferably 0.1% by mass or greater and 5% by mass or less, more preferably 0.2% by mass or greater and 3% by mass or less, and still more preferably 0.2% by mass or greater and 1% by mass or less with respect to the total mass of the flux.

The flux according to the present embodiment contains an amine and preferably an alkanolamine so that the wettability is likely to be enhanced and the ability to suppress the generation of voids is likely to be enhanced.

### [Halogen compound]

Examples of the halogen compound include an amine hydrohalic acid salt, and organic halogen compounds other than the amine hydrohalic acid salt.

The amine hydrohalic acid salt is a compound obtained by reacting an amine with a hydrogen halide.

Examples of the amine herein include those described above in the section of <<Amine>>.

In addition, as the halogen compound other than the amine hydrohalic acid salt, for example, a salt obtained by reacting an amine with tetrafluoroboric acid (HBF₄) or a complex obtained by reacting an amine with boron trifluoride (BF₃) can also be used. Examples of the complex include boron trifluoride piperidine.

Examples of the halogen compound other than the amine hydrohalic acid salt include a halogenated aliphatic compound. The halogenated aliphatic hydrocarbon group denotes a group in which some or all hydrogen atoms constituting the aliphatic hydrocarbon group are substituted with halogen atoms.

Examples of the halogenated aliphatic compound include halogenated aliphatic alcohol and a halogenated heterocyclic compound.

Examples of the halogenated aliphatic alcohol include 1-bromo-2-propanol, 3-bromo-1-propanol, 3-bromo-1,2-propanediol, 1-bromo-2-butanol, 1,3-dibromo-2-propanol, 2,3-dibromo-1-propanol, 1,4-dibromo-2-butanol, and trans-2,3-dibromo-2-butene-1,4-diol.

Examples of the halogenated heterocyclic compounds include a compound represented by General Formula (h1).

R^{h11}-(R^{h12})ₙ (h1)

[In the formula, R^{h11} represents an n-valent heterocyclic group. R^{h12} represents a halogenated aliphatic hydrocarbon group.]

Examples of the heterocyclic ring of the n-valent heterocyclic group as R^{h11} include a ring structure in which some of the carbon atoms constituting an aliphatic hydrocarbon or an aromatic hydrocarbon ring are substituted with heteroatoms. Examples of the heteroatom in the heterocyclic ring include an oxygen atom, a sulfur atom, and a nitrogen atom. This heterocyclic ring is preferably a 3- to 10-membered ring and more preferably a 5- to 7-membered ring. Examples of the heterocyclic ring include an isocyanurate ring.

The halogenated aliphatic hydrocarbon group as R^{h12} has preferably 1 to 10 carbon atoms, more preferably 2 to 6 carbon atoms, and still more preferably 3 to 5 carbon atoms. In addition, R^{h12} represents preferably a brominated aliphatic hydrocarbon group or a chlorinated aliphatic hydrocarbon group, more preferably a brominated aliphatic hydrocarbon group, and still more preferably a brominated saturated aliphatic hydrocarbon group.

Examples of the halogenated heterocyclic compound include tris-(2,3-dibromopropyl)isocyanurate.

In addition, examples of the halogen compound other than the amine hydrohalic acid salt include halogenated carboxyl compounds, for example, carboxyl iodide compounds such as 2-iodobenzoic acid, 3-iodobenzoic acid, 2-iodopropionic acid, 5-iodosalicylic acid, and 5-iodoanthranilic acid; carboxyl chloride compounds such as 2-chlorobenzoic acid and 3-chloropropionic acid; and carboxyl bromide compounds such as 2,3-dibromopropionic acid, 2,3-dibromosuccinic acid, and 2-bromobenzoic acid.

In addition, examples of the halogen compound other than the amine hydrohalic acid salt include an organic chloro compound. Examples of the organic chloro compound include chloroalkane, chlorinated fatty acid ester, chlorendic acid, and a chlorendic anhydride.

The halogen compound may be used alone or in the form of a mixture of two or more kinds thereof.

### <<Organic phosphorus compound>>

Examples of the organic phosphorus compound include acidic phosphoric acid ester, acidic phosphonic acid ester, and acidic phosphinic acid ester.

The organic phosphorus compound may be used alone or in the form of a mixture of two or more kinds thereof.

### <<Thixotropic agent>>

Examples of the thixotropic agents include an ester-based thixotropic agent, an amide-based thixotropic agent, and a sorbitol-based thixotropic agent.

Examples of the ester-based thixotropic agent include an ester compound, and specific examples thereof include cured castor oil and ethyl myristate.

Examples of the amide-based thixotropic agent include monoamide, bisamide, and polyamide.

Examples of the monoamide include lauric acid amide, palmitic acid amide, stearic acid amide, behenic acid amide, hydroxystearic acid amide, saturated fatty acid amide, oleic acid amide, erucic acid amide, unsaturated fatty acid amide, 4-methylbenzamide (p-toluamide), p-toluene methanamide, aromatic amide, hexamethylene hydroxystearic acid amide, substituted amide, methylolstearic acid amide, methylolamide, and fatty acid ester amide.

Examples of the bisamide include ethylenebis fatty acid (fatty acid having 6 to 24 carbon atoms) amide, ethylenebis hydroxy fatty acid (fatty acid having 6 to 24 carbon atoms) amide, hexamethylenebis fatty acid (fatty acid having 6 to 24 carbon atoms) amide, hexamethylenebis hydroxy fatty acid (fatty acid having 6 to 24 carbon atoms) amide, and aromatic bisamide. Examples of the fatty acids that are raw materials of the bisamide include stearic acid (having 18 carbon atoms), oleic acid (having 18 carbon atoms), and lauric acid (having 12 carbon atoms).

Examples of the polyamides include polyamides such as saturated fatty acid polyamides, unsaturated fatty acid polyamides, aromatic polyamides, 1,2,3-propanetricarboxylic acid tris(2-methylcyclohexylamide), cyclic amide oligomers, and acyclic amide oligomers.

Examples of the above-described cyclic amide oligomers include an amide oligomer in which a dicarboxylic acid and a diamine are cyclically polycondensed, an amide oligomer in which a tricarboxylic acid and a diamine are cyclically polycondensed, an amide oligomer in which a dicarboxylic acid and a triamine are cyclically polycondensed, an amide oligomer in which a tricarboxylic acid and a triamine are cyclically polycondensed, an amide oligomer in which a dicarboxylic acid and a tricarboxylic acid, and a diamine are cyclically polycondensed, an amide oligomer in which a dicarboxylic acid and a tricarboxylic acid, and a triamine are cyclically polycondensed, an amide oligomer in which a dicarboxylic acid, and a diamine and a triamine are cyclically polycondensed, an amide oligomer in which a tricarboxylic acid, and a diamine and a triamine are cyclically polycondensed, and an amide oligomer in which a dicarboxylic acid and a tricarboxylic acid, and a diamine and a triamine are cyclically polycondensed.

Further, examples of the above-described acyclic amide oligomers include an amide oligomer in which a monocarboxylic acid, and a diamine and/or a triamine are acyclically polycondensed and an amide oligomer in which a dicarboxylic acid and/or a tricarboxylic acid, and a monoamine are acyclically polycondensed. In the case of an amide oligomer containing a monocarboxylic acid or a monoamine, the monocarboxylic acid and the monoamine function as terminal molecules so that an acyclic amide oligomer having a reduced molecular weight is obtained. Further, in a case where the acyclic amide oligomer is an amide compound in which a dicarboxylic acid and/or a tricarboxylic acid, and a diamine and/or a triamine are acyclically polycondensed, an acyclic polymer-based amide polymer is obtained. Further, the acyclic amide oligomer also includes an amide oligomer in which a monocarboxylic acid and a monoamine are acyclically condensed.

Examples of the sorbitol-based thixotropic agent include dibenzylidene-D-sorbitol, bis(4-methylbenzylidene)-D-sorbitol, (D-)sorbitol, monobenzylidene(-D-)sorbitol, and mono(4-methylbenzylidene)-(D-)sorbitol.

The flux according to the present embodiment may or may not contain a thixotropic agent. In a case where the flux according to the present embodiment contains the thixotropic agent, the thixotropic agent may be used alone or in the form of a mixture of two or more kinds thereof.

### <<Metal deactivator>>

Examples of the metal deactivator include hindered phenolic compounds and nitrogen compounds.

The term "metal deactivator" herein denotes a compound showing a performance of preventing a metal from deteriorating due to contact with a certain kind of compound.

The hindered phenolic compound denotes a phenolic compound having a bulky substituent (for example, a branched or cyclic alkyl group such as a t-butyl group) on at least one of the ortho positions of phenol.

The hindered phenolic compound is not particularly limited, and examples thereof include bis[3-(3-tert-butyl-4-hydroxy-5-methylphenyl)propionic acid][ethylenebis(oxyethylene)], N,N'-hexamethylenebis[3-(3,5-di-tert-butyl-4-hydroxyphenyl)propanamide], 1,6-hexanediol bis[3-(3,5-di-tert-butyl-4-hydroxyphenyl)propionate], 2,2'-dihydroxy-3,3'-bis(α-methylcyclohexyl)-5,5'-dimethyldiphenylmethane, 2,2'-methylenebis(6-tert-butyl-p-cresol), 2,2'-methylenebis(6-tert-butyl-4-ethylphenol), triethylene glycol-bis[3-(3-tert-butyl-5-methyl-4-hydroxyphenyl)propionate], 1,6-hexanediol-bis-[3-(3,5-di-tert-butyl-4-hydroxyphenyl)propionate], 2,4-bis-(n-octylthio)-6-(4-hydroxy-3,5-di-t-butylanilino)-1,3,5-triazine, pentaerythrityl-tetrakis[3-(3,5-di-tert-butyl-4-hydroxyphenyl)propionate], 2,2-thio-diethylenebis[3-(3,5-di-tert-butyl-4-hydroxyphenyl)propionate], octadecyl-3-(3,5-di-tert-butyl-4-hydroxyphenyl)propionate, N,N'-hexamethylenebis(3,5-di-t-butyl-4-hydroxy-hydrocinnamamide), 3,5-di-tert-butyl-4-hydroxybenzylphosphonate-diethyl ester, 1,3,5-trimethyl-2,4,6-tris(3,5-di-tert-butyl-4-hydroxybenzyl)benzene, N,N'-bis[2-[2-(3,5-di-tert-butyl-4-hydroxyphenyl)ethylcarbonyloxy]ethyl]oxamide, and a compound represented by the following chemical formula. 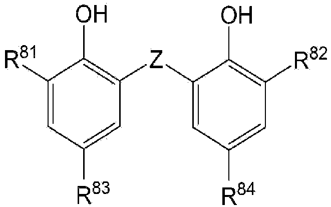 (In the formula, Z represents an alkylene group which may be substituted. R⁸¹ and R⁸² each independently represent an alkyl group, an aralkyl group, an aryl group, a heteroaryl group, a cycloalkyl group, or a heterocycloalkyl group, which may be substituted. R⁸³ and R⁸⁴ each independently represent an alkyl group that may be substituted.)

Examples of the nitrogen compound in the metal deactivator include hydrazide-based nitrogen compounds, amide-based nitrogen compounds, triazole-based nitrogen compounds, and melamine-based nitrogen compounds.

The hydrazide-based nitrogen compound may be a nitrogen compound having a hydrazide skeleton, and examples thereof include dodecanedioic acid bis[N2-(2-hydroxybenzoyl)hydrazide, N,N'-bis[3-(3,5-di-tert-butyl-4-hydroxyphenyl)propionyl]hydrazine, decanedicarboxylic acid disalicyloyl hydrazide, N-salicylidene-N'-salicyl hydrazide, m-nitrobenzene hydrazide, 3-aminophthalhydrazide, phthalic acid dihydrazide, adipic acid hydrazide, oxalobis(2-hydroxy-5-octylbenzylidene hydrazide), N'-benzoylpyrrolidone carboxylic acid hydrazide, and N,N'-bis(3-(3,5-di-tert-butyl-4-hydroxyphenyl)propionyl)hydrazine.

The amide-based nitrogen compound may be a nitrogen compound having an amide skeleton, and examples thereof include N,N'-bis{2-[3-(3,5-di-tert-butyl-4-hydroxyphenyl)propionyloxyl]ethyl}oxamide.

The triazole-based nitrogen compound may be a nitrogen compound having a triazole skeleton, and examples thereof include N-(2H-1,2,4-triazol-5-yl) salicylamide, 3-amino-1,2,4-triazole and 3-(N-salicyloyl)amino-1,2,4-triazole.

The melamine-based nitrogen compound may be a nitrogen compound having a melamine skeleton, and examples thereof include melamine and melamine derivatives. More specific examples thereof include trisaminotriazine, alkylated trisaminotriazine, alkoxyalkylated trisaminotriazine, melamine, alkylated melamine, alkoxyalkylated melamine, N2-butylmelamine, N2,N2-diethylmelamine, and N,N,N',N',N",N" - hexakis(methoxymethyl)melamine.

The metal deactivator may be used alone or in the form of a mixture of two or more kinds thereof.

### <<Surfactant>>

Examples of the surfactants include nonionic surfactants.

Examples of the nonionic surfactants include polyoxyalkylene adducts.

Examples of alkylene oxides from which the polyoxyalkylene adducts are derived include ethylene oxides, propylene oxides, and butylene oxides.

Examples of the polyoxyalkylene adducts include polyethylene glycol, polypropylene glycol, polyethylene glycol-polypropylene glycol copolymers, ethylene oxide-resorcinol copolymers, polyoxyalkylene acetylene glycols, polyoxyalkylene glyceryl ethers, polyoxyalkylene alkyl ethers, polyoxyalkylene esters, and polyoxyalkylene alkylamides.

Alternatively, examples of the nonionic surfactants include polyoxyalkylene adducts of alcohols. Examples of the alcohols include aliphatic alcohols, aromatic alcohols, and polyhydric alcohols.

The surfactant may be used alone or in the form of a mixture of two or more kinds thereof.

### <<Antioxidant>>

Examples of the antioxidants include hindered phenolic antioxidants such as 2,2'-dihydroxy-3,3'-bis(α-methylcyclohexyl)-5,5'-dimethyldiphenylmethane.

The term "antioxidant" described herein denotes a compound having a performance of suppressing oxidation of a solder alloy.

The antioxidant may be used alone or in the form of a mixture of two or more kinds thereof.

In the implementation of the indium sheet, since the melting point of indium constituting the sheet is a low temperature of 156°C, the reflow is performed under a low temperature condition.

The flux according to the present embodiment has high wettability even in a case where bonding is performed at a relatively low temperature, and can enhance the ability to suppress the generation of voids. The reason why such an effect is exhibited is not clear, but is presumed as follows.

The monocarboxylic acid (A1) such as palmitic acid has a melting point lower than the melting point of a dicarboxylic acid such as adipic acid. Since the flux according to the present embodiment contains the monocarboxylic acid (A1) having a relatively low melting point, the wettability can be sufficiently exhibited even in a case where the reflow is performed at a relatively low temperature.

Since the reactivity of the monocarboxylic acid (A1) due to the carboxy group is lower than the reactivity of the dicarboxylic acid, the amount of voids derived from the reaction between the carboxylic acid and the metal oxide can also be reduced.

The solvent (S1) having a boiling point of 100°C or lower is volatilized before the indium sheet is melted even in a case where the reflow is performed at a low temperature. As a result, voids derived from the solvent (S1) are not generated in a case where indium is melted.

Due to these synergistic effects, the flux according to the present embodiment can suppress the generation of voids even in the implementation of the indium sheet.

Since the flux according to the present embodiment exhibits the above-described effects, the flux can be suitably used for implementing an indium sheet.

### (Method for producing bonded object)

The method for producing a bonded object according to the present aspect is a method of obtaining a bonded object by bonding a die and a lid to each other through a thermal interface material (TIM) using the flux according to the above-described embodiment.

The method for producing a bonded object according to the present aspect will be described using, as an example, a method including a flux applying step, a lid mounting step, and a reflow step.

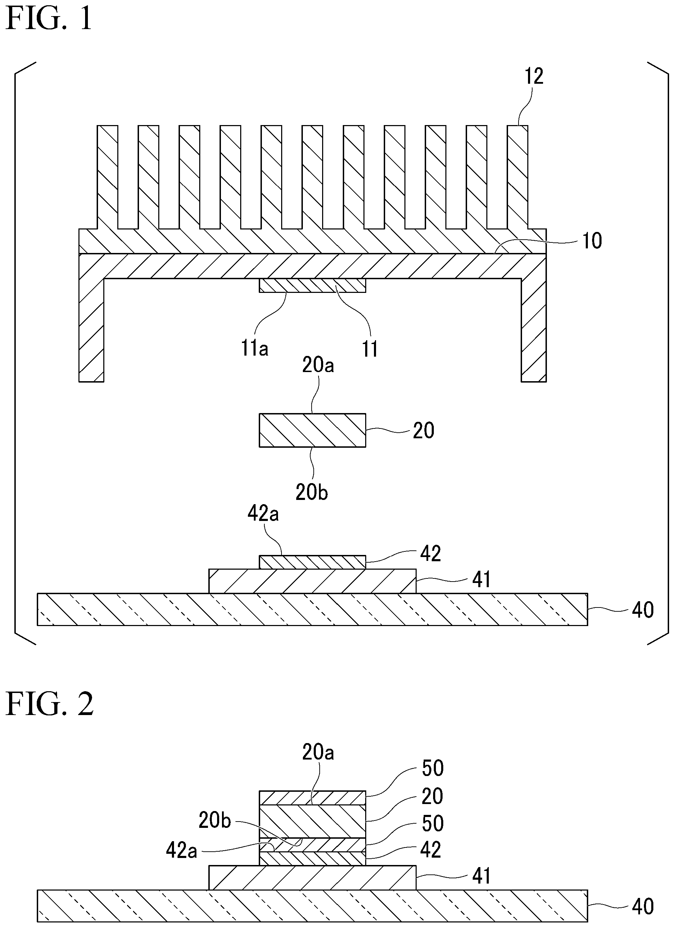

A suitable embodiment of the method for producing a bonded object according to the present aspect will be described with reference to FIGS. 1 to 3. In a method for producing the bonded object according to the present embodiment, a substrate 40 on which a lid 10, a TIM 20, and a die 41 are installed is prepared as shown in FIG. 1.

A metalized layer 42 is provided on a surface of the die 41. The metalized layer 42 may be, for example, a Ni plating layer, a Ni/Au plating layer, or the like. The metalized layer 42 may have a plurality of layers having different compositions. The metalized layer 42 can be formed by, for example, a method such as sputtering.

The lid 10 is provided with a metalized layer 11 on a surface facing the TIM 20. Examples of the metalized layer 11 include the same layers as those for the metalized layer 42 of the die 41. The lid 10 includes the heat sink 12 on a surface opposite to the surface facing the TIM 20. Examples of the material of the heat sink 12 include metals such as aluminum, iron, and copper.

TIM20 is an indium sheet formed of only indium. The TIM 20 has a plate shape. The dimensions of the TIM 20 are the same as or smaller than the dimensions of the metalized layer 11 of the lid 10 and the metalized layer 42 of the die 41.

### <Flux applying step>

As a flux 50, the flux 50 according to the above-described embodiment is suitably used. The flux applying step will be described with reference to FIG. 2. FIG. 2 is a cross-sectional view showing the TIM 20 and the die 41 which are coated with the flux 50. In the flux applying step, the flux 50 is sandwiched between the TIM 20 and the die 41 and between the TIM 20 and the lid 10.

In the flux applying step, the bonding surfaces (42a, 20b) between the die 41 and the TIM 20 and the bonding surfaces (11a, 20a) between the lid 10 and the TIM 20 are coated with the flux 50.

The bonding surface is coated with the flux 50 in the following manner. The surface 42a of the metalized layer 42 of the die 41 is coated with the flux 50. Next, the TIM 20 is placed on the metalized layer 42 of the die 41 coated with the flux 50. The surface 20a of the TIM 20 laminated on the die 41, on a side opposite to the surface 20b in contact with the die 41, is coated with the flux 50.

Examples of the application device for the flux 50 include a spray fluxer and a foam fluxer. Among these, a spray fluxer is preferable from the viewpoint of the stability of the application amount.

### <Lid mounting step>

In the lid mounting step, the bonding surface is coated with the flux 50, and the lid 10 is fixed to the substrate 40 on which the TIM 20 and the die 41 are laminated.

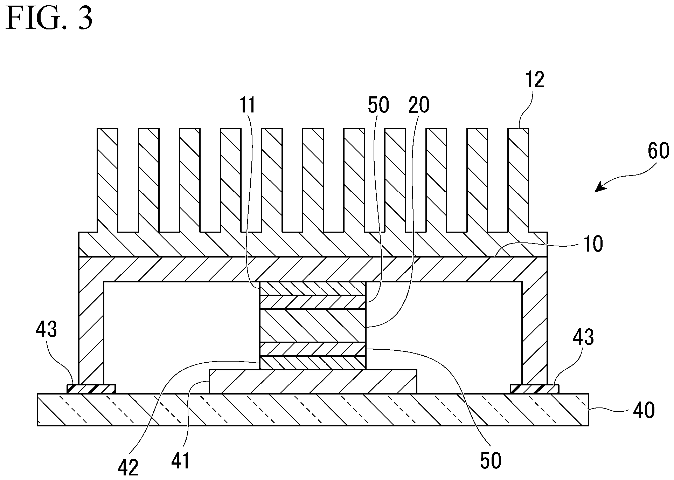

The lid mounting step will be described with reference to FIG. 3. FIG. 3 is a view showing a laminate 60 in which the lid 10 and the substrate 40 adhere to each other by an adhesive resin 43 after the application of the flux 50.

In the lid mounting step, one surface of the substrate 40 is coated with the adhesive resin 43 after the application of the flux 50. Next, the lid 10 and the substrate 40 on which the TIM 20 and the die 41 are laminated are subjected to thermocompression bonding to cure the adhesive resin 43. In this manner, the lid 10 is fixed to the substrate 40. The laminate 60 in which the lid 10 and the substrate 40 adhere to each other by the adhesive resin 43 is obtained by performing the lid mounting step.

### <Reflow step>

In the reflow step, the laminate 60 is subjected to reflow. The lid 10 and the die 41 are bonded to each other through the TIM 20 by reflow.

The reflow temperature is preferably lower than 200°C. Since the indium constituting the indium sheet which is the TIM has a melting point of 156°C, bonding can be performed even at a temperature lower than that of typical reflow. The reflow temperature is preferably in a range of 160°C to 200°C and more preferably in a range of 170°C to 190°C.

According to a method for bonding the bonded object of the embodiment described above, since the flux according to the embodiment described above has excellent wettability even at a low temperature, the adhesiveness of the TIM to the lid and the die is likely to be enhanced. As a result, the die and the lid can be favorably bonded to each other by the TIM (that is, the indium sheet).

In addition, since the amount of voids in the bonding surface of the indium sheet is reduced in the bonded object bonded as described above, it is possible to efficiently dissipate heat generated from the die.

### (Other embodiments)

As described above, in the method for producing a bonded object according to the present aspect, the flux 50 is sandwiched between at least one of the TIM 20 and the die 41 or the TIM 20 and the lid 10.

In the above-described embodiment, the bonding surface 42a of the die 41 to the TIM 20 and the bonding surface 11a of the TIM 20 to the lid 10 are coated with the flux 50, but the surface coated with the flux 50 is not limited thereto.

For example, the bonding surface 20b of the TIM 20 to the die 41 may be coated with the flux 50, or the bonding surface 11a of the lid 10 to the TIM 20 may be coated with the flux 50 in order to sandwich the flux 50 between the TIM 20 and the die 41. Examples

Hereinafter, the present invention will be described based on the examples, but the present invention is not limited to the following examples.

### <Preparation of flux>

### (Examples 1 to 45 and Comparative Examples 1 to 4)

Fluxes of each of examples and comparative examples were blended using the compositions shown in Tables 1 to 6. The components of the raw materials used are shown below. The compositional ratios in Tables 1 to 6 are in units of % by mass in a case where the total mass of the flux is set to 100% by mass, and the blank means 0% by mass.

### Rosin: acrylic acid-modified hydrogenated rosin, hydrogenated rosin

A monocarboxylic acid (A1) and a dicarboxylic acid were used as the organic acid.
Monocarboxylic acid (A1): lauric acid (melting point: 45°C, molecular weight: 200), palmitic acid (melting point: 63°C, melting point: 256), stearic acid (melting point: 70°C, melting point: 284), 12-hydroxystearic acid (melting point: 76.5°C, molecular weight: 300)
Dicarboxylic acid: eicosanedioic acid, adipic acid, sebacic acid
Amine: diethanolamine

As the solvent (S), a solvent (S1) and a solvent (S2) were used.
Solvent (S1): 2-propanol (boiling point: 82°C)
Solvent (S2): diethylene glycol monohexyl ether (boiling point: 259°C)

A bonded object was produced by the evaluation method described in <Evaluation 1> below, and <<Evaluation of ability to suppress generation of voids>> and <<Evaluation of wettability>> were performed. These evaluation results are shown in Tables 1 to 5.

### <Evaluation 1>

### <<Evaluation of ability to suppress generation of voids>>

Method for producing bonded object:
A lid having a surface provided with an Au/Ni plating portion (size: 8 mm × 8 mm) and a substrate having a surface provided with an Au/Ni plating portion (size: 8 mm × 8 mm) were prepared.

An indium sheet (size: 7 mm × 7 mm × 400 µm) formed of only indium was prepared as a solder sheet. The surface and the rear surface of the indium sheet was spray-coated with 2 mg of the flux of each example.

A copper plate having a thickness of 300 µm was placed as a spacer on the periphery of the Au/Ni plating portion of the substrate. Next, the indium sheet coated with the flux was fixed with a clip in a state of being sandwiched between the lid and the Au/Ni plating portion of the substrate.

Next, the lid and the substrate with the solder sheet sandwiched therebetween were subjected to reflow to obtain a bonded object. The reflow was performed by raising the temperature at a temperature rising rate of 10°C/min in the atmosphere until the temperature reached 170°C.

### Verification method:

The obtained bonded object was irradiated with X-rays in the vertical direction of the substrate, and the transmitted X-rays were analyzed to measure the void area. XD7600NT (manufactured by Nordson Corporation) was used for the measurement. In the measurement of the void area, in a case where X-rays passed through at least one void, the measurement was made assuming that voids were present. Voids having a diameter of 0.1 µm or greater were detected. Next, the proportion of the total area of the voids in the total area of the indium sheet was calculated and defined as a void area ratio (%).

### Determination standards:

A: The void area ratio was less than 10%.
B: The void area ratio was 10% or greater less than 15%.
C: The void area ratio was 15% or greater.

The flux with an evaluation result of A or B was regarded as acceptable, and the flux with an evaluation result of C was regarded as unacceptable.

### <<Evaluation of wettability>>

### Verification method:

An indium sheet (size: 2 mm × 2 mm × 100 µm) formed of only indium was prepared as a solder sheet.

The surface and the rear surface of the indium sheet was spray-coated with 0.5 mg of the flux of each example. The solder sheet coated with the flux was placed on the Au/Ni electrode.

Next, the electrode on which the indium sheet was placed was subjected to reflow under the following conditions. The reflow was performed by raising the temperature to 180°C at a temperature rising rate of 6 °C/min and holding the temperature at 180°C for 3 minutes.

Next, the area of the wet spread was measured after removal of the flux.

### Determination standards:

A: The area of the wet spread was 2.5 mm² or greater.
B: The area of the wet spread was 2.0 mm² or greater and less than 2.5 mm².

The flux with an evaluation result of A or B was regarded as acceptable.

<<Evaluation of ability to suppress generation of voids>> and <<Evaluation of wettability>> were carried out by the evaluation method described in <Evaluation 2> below. The evaluation results thereof are listed in Table 6.

### <Evaluation 2>

### <<Evaluation of ability to suppress generation of voids>>

A SAC alloy sheet (size: 7 mm × 7 mm × 400 µm) formed of a solder alloy of 3% by mass of Ag, 0.5% by mass of Cu, and Sn as a remainder was prepared as a solder sheet.

The verification was carried out using the SAC alloy sheet and the fluxes of Example 5 and Comparative Example 3 by the same method as in <<Evaluation of ability to suppress generation of void>> of <Evaluation 1>. Here, the reflow was performed by raising the temperature at a temperature rising rate of 30°C/min in the atmosphere until the temperature reached 250°C.

### <<Evaluation of wettability>>

A SAC alloy sheet (size: 2 mm × 2 mm × 100 µm) formed of a solder alloy of 3% by mass of Ag, 0.5% by mass of Cu, and Sn as a remainder was prepared as a solder sheet.

The verification was carried out using the SAC alloy sheet and the fluxes of Example 5 and Comparative Example 3 by the same method as in <<Evaluation of wettability>> of <Evaluation 1>. Here, the reflow was performed by raising the temperature at a temperature rising rate of 6°C/min until the temperature reached 250°C and holding the temperature at 250°C for 3 minutes.

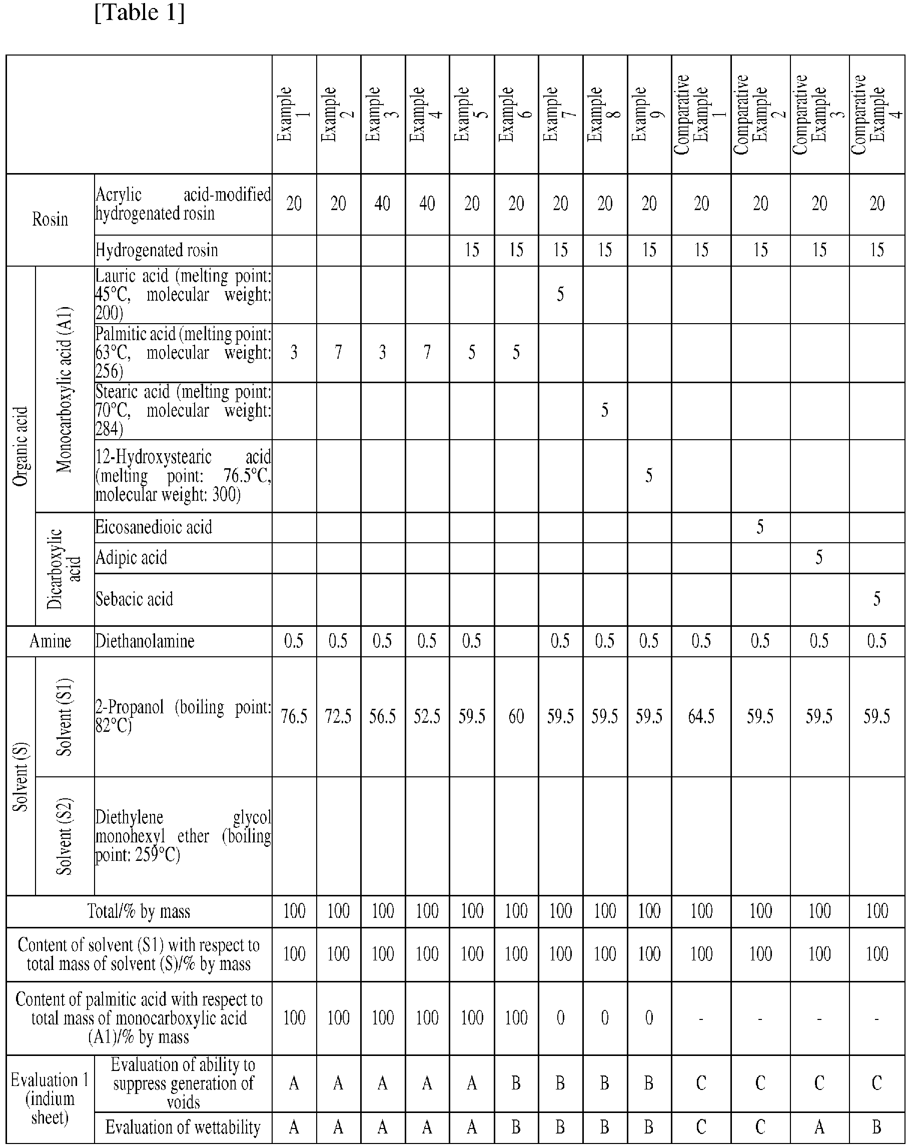

In the fluxes of Examples 1 to 9, which contained the monocarboxylic acid (A1) having a melting point of 35°C or higher and 90°C or lower, the evaluation of the ability to suppress generation of voids was A or B.

In the fluxes of Comparative Examples 1 to 4, which did not contain the monocarboxylic acid (A1), the evaluation of the ability to suppress generation of voids was C.

In the flux of Example 5, which contained palmitic acid, the evaluation of the ability to suppress generation of voids was A. In the fluxes of Examples 7 to 9, which contained lauric acid, stearic acid, or 12-hydroxystearic acid, the evaluation of the ability to suppress generation of voids was B.

In the flux of Example 5, which contained an alkanolamine, the evaluation of the ability to suppress generation of voids and the evaluation of the wettability were A.

In the flux of Example 6, which did not contain an alkanolamine, the evaluation of the ability to suppress generation of voids and the evaluation of the wettability were B.

**[Table 2]**

| | | | Example to | Example 11 | Example 12 | Example 13 |
|---|---|---|---|---|---|---|
| Rosin | | Acrylic acid-modified hydrogenated rosin | 20 | 20 | 20 | 20 |
| | | Hydrogenated rosin | 15 | 15 | 15 | 15 |
| Organic acid | Monocarboxylic acid (A1) | Lauric acid (melting point: 45°C, molecular weight: 200) | | | | |
| | | Palmitic acid (melting point: 63°C, molecular weight: 256) | 5 | 5 | 5 | 5 |
| | | Stearic acid (melting point: 70°C, molecular weight: 284) | 3 | 4 | | |
| | | 12-Hydroxystearic acid (melting point: 76.5°C, molecular weight: 300) | | | | |
| | Dicarboxylic acid | Eicosanedioic acid | | | | |
| | | Adipic acid | | | | |
| | | Sebacic acid | | | | |
| Amine | | Diethanolamine | 0.5 | 0.5 | 0.5 | 0.5 |
| Solvent (S) | Solvent (S1) | 2-Propanol (boiling point: 82°C) | 56.5 | 55.5 | 39.5 | 36.5 |
| | Solvent (S2) | Diethylene glycol monohexyl ether (boiling point: 259°C) | | | 20 | 23 |
| Total/% by mass | | | 100 | 100 | 100 | 100 |
| Content of solvent (S1) with respect to total mass of solvent (S)/% by mass | | | 100 | 100 | 66.4 | 61.3 |
| Content of palmitic acid with respect to total mass of monocarboxylic acid (Al)/% by mass | | | 62.5 | 55.6 | 100 | 100 |
| Evaluation 1 (indium sheet) | | Evaluation of ability to suppress generation of voids | A | B | A | B |
| | | Evaluation of wettability | A | A | A | A |

In the flux of Example 10 in which the content of the palmitic acid was 60% by mass or greater with respect to the total mass of the monocarboxylic acid (A1), the evaluation of the ability to suppress generation of voids was A.

In the flux of Example 11 in which the content of the palmitic acid was less than 60% by mass with respect to the total mass of the monocarboxylic acid (A1), the evaluation of the ability to suppress generation of voids was B.

In the flux of Example 12 in which the content of the solvent (S1) was 65% by mass or greater with respect to the total mass of the solvent (S), the evaluation of the ability to suppress generation of voids was A.

In the flux of Example 13 in which the content of the solvent (S1) was less than 65% by mass with respect to the total mass of the solvent (S), the evaluation of the ability to suppress generation of voids was B.

**[Table 3]**

| | | | Example 14 | Example 15 | Example 16 | Example 17 | Example 18 | Example 19 | Example 20 | Example 21 |
|---|---|---|---|---|---|---|---|---|---|---|
| Rosin | | Acrylic acid-modified hydrogenated rosin | 20 | 20 | 40 | 40 | 20 | 40 | 20 | 40 |
| | | Hydrogenated rosin | | | | | | | | |
| Organic acid | Monocarboxylic acid (Al) | Lauric acid (melting point: 45°C, molecular weight: 200) | | | | | | | | |
| | | Palmitic acid (melting point: 63°C, molecular weight: 256) | 1 | 10 | 1 | 10 | 15 | 15 | 20 | 20 |
| | | Stearic acid (melting point: 70°C, molecular weight: 284) | | | | | | | | |
| | | 12-Hydroxystearic acid (melting point: 76.5°C, molecular weight: 300) | | | | | | | | |
| | Dicarboxylic acid | Eicosanedioic acid | | | | | | | | |
| | | Adipic acid | | | | | | | | |
| | | Sebacic acid | | | | | | | | |
| Amine | | Diethanolamine | 0.5 | 0.5 | 0.5 | 0.5 | 0.5 | 0.5 | 0.5 | 0.5 |
| Solvent (S) | Solvent (S1) | 2-Propanol (boiling point: 82°C) | 78.5 | 69.5 | 58.5 | 49.5 | 64.5 | 44.5 | 59.5 | 39.5 |
| | Solvent (S2) | Diethylene glycol monohexyl ether (boiling point: 259°C) | | | | | | | | |
| Total/% by mass | | | 100 | 100 | 100 | 100 | 100 | 100 | 100 | 100 |
| Content of solvent (S1) with respect to total mass of solvent (S)/% by mass | | | 100 | 100 | 100 | 100 | 100 | 100 | 100 | 100 |
| Content of palmitic acid with respect to total mass of monocarboxylic acid (Al)/% by mass | | | 100 | 100 | 100 | 100 | 100 | 100 | 100 | 100 |
| Evaluation 1 (indium sheet) | | Evaluation of ability to suppress generation of voids | A | A | A | A | A | A | B | B |
| | | Evaluation of wettability | A | A | A | A | A | A | A | A |

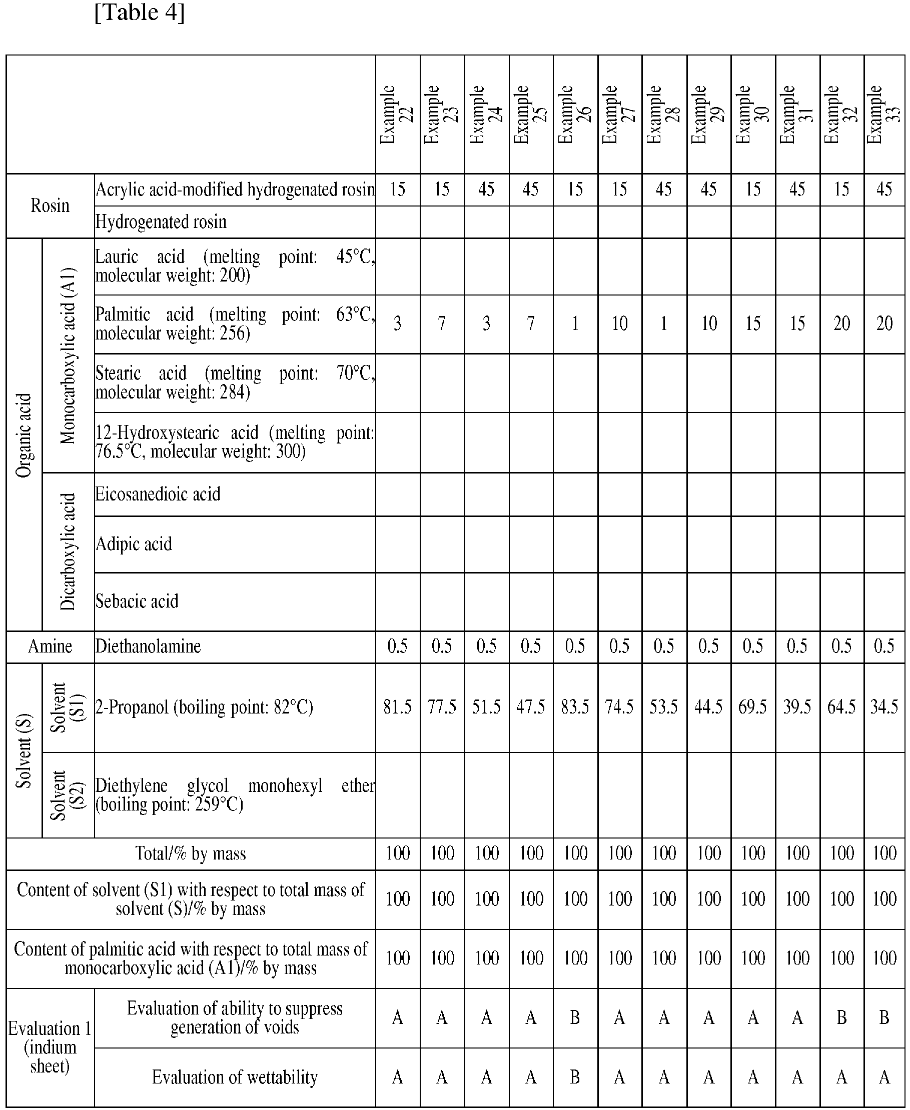

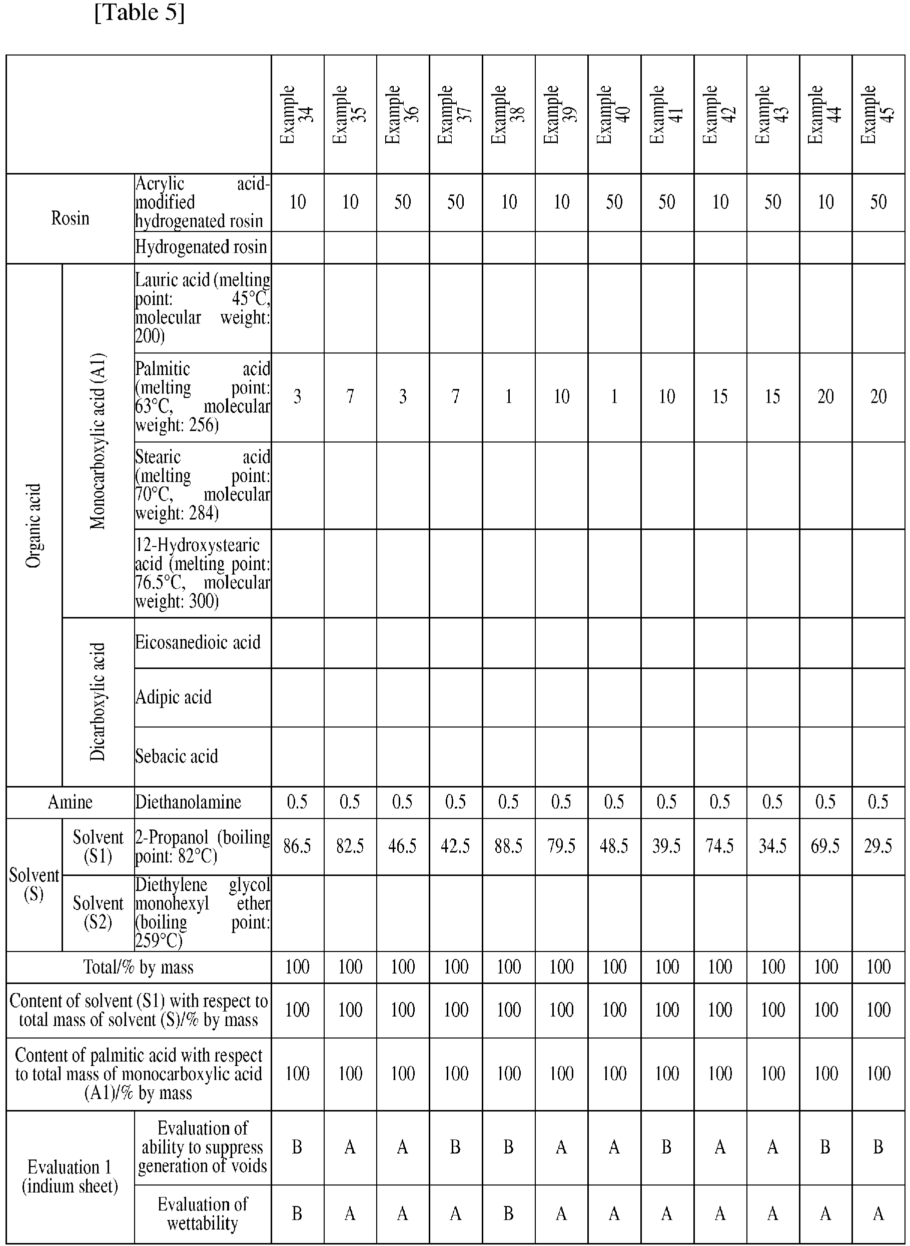

In the fluxes of Examples 15, 17 to 19, 22 to 25, 27, and 29 to 31 in which the total content of the rosin was 15% by mass or greater and 45% by mass or less with respect to the total mass of the flux, and the content of palmitic acid was 3% by mass or greater and 15% by mass or less with respect to the total mass of the flux, the evaluation of the ability to suppress generation of voids and the evaluation of the wettability were A.

In the fluxes of Examples 34 and 38 in which the total content of the rosin was 10% by mass with respect to the total mass of the flux, the evaluation of the ability to suppress generation of voids and the evaluation of the wettability were B.

In the fluxes of Examples 37, 41, and 45 in which the total content of the rosin was 50% by mass with respect to the total mass of the flux, the evaluation of the ability to suppress generation of voids was B.

In the fluxes of Examples 26 and 38 in which the content of palmitic acid was 1% by mass with respect to the total mass of the flux, the evaluation of the ability to suppress generation of voids and the evaluation of the wettability were B.

In the fluxes of Examples 20, 21, 32, 33, 44, and 45 in which the content of palmitic acid was 20% by mass with respect to the total mass of the flux, the evaluation of the ability to suppress generation of voids was B.

**[Table 6]**

| | | | Example 5 | Comparative Example 3 |
|---|---|---|---|---|
| Rosin | | Acrylic acid-modified hydrogenated rosin | 20 | 20 |
| | | Hydrogenated rosin | 15 | 15 |
| Organic acid | Monocarboxylic acid (A1) | Lauric acid (melting point: 45°C, molecular weight: 200) | | |
| | | Palmitic acid (melting point: 63°C, molecular weight: 256) | 5 | |
| | | Stearic acid (melting point: 70°C, molecular weight: 284) | | |
| | | 12-Hydroxystearic acid (melting point: 76.5°C, molecular weight: 300) | | |
| | Dicarboxylic acid | Eicosanedioic acid | | |
| | | Adipic acid | | 5 |
| | | Sebacic acid | | |
| Amine | | Diethanolamine | 0.5 | 0.5 |
| Solvent (S) | Solvent (S1) | 2-Propanol (boiling point: 82°C) | 59.5 | 59.5 |
| | Solvent (S2) | Diethylene glycol monohexyl ether (boiling point: 259°C) | | |
| Total/% by mass | | | 100 | 100 |
| Content of solvent (S1) with respect to total mass of solvent (S)/% by mass | | | 100 | 100 |
| Content of palmitic acid with respect to total mass of monocarboxylic acid (Al)/% by mass | | | 100 | - |
| Evaluation 1 (indium sheet) | | Evaluation of ability to suppress generation of voids | A | C |
| | | Evaluation of wettability | A | A |
| Evaluation 2 (SAC alloy sheet) | | Evaluation of ability to suppress generation of voids | A | A |
| | | Evaluation of wettability | A | A |

In <<Evaluation 2>>, in a case where the SAC alloy sheet and the flux of Example 5 were used, the evaluation of the ability to suppress generation of voids and the evaluation of the wettability were A. In addition, in a case where the SAC alloy sheet and the flux of Comparative Example 3 were used, the evaluation of the ability to suppress generation of voids and the evaluation of the wettability were A.

In the flux of Comparative Example 3, which did not contain the monocarboxylic acid (A1), the ability of suppressing voids was evaluated as A in a case where the SAC alloy sheet was used, and the ability of suppressing voids was evaluated as C in a case where the indium sheet was used. That is, the indium sheet is more likely to generate voids than the SAC alloy sheet.

The flux of Example 5, which contained the monocarboxylic acid (A1), was able to sufficiently suppress voids even in a case where the indium sheet was used.

### INDUSTRIAL APPLICABILITY

The flux of the present invention is suitably used for producing a bonded object with high heat discharge efficiency, in which a lid provided with a heat sink and a die are bonded to each other by an indium sheet.

### REFERENCE SIGNS LIST

10 Lid
11 Metalized layer
11a Bonding surface
12 Heat sink
20 Thermal interface material (TIM)
20a, 20b Bonding surface
40 Substrate
41 Die
42 Metalized layer
42a Bonding surface
43 Adhesive resin
50 Flux
60 Laminate

## Claims

1. A flux comprising:
a rosin;
an organic acid; and
a solvent (S),
wherein the organic acid includes a monocarboxylic acid (A1) having a melting point of 35°C or higher and 90°C or lower, and
the solvent (S) includes a solvent (S1) having a boiling point of 100°C or lower.

2. The flux according to Claim 1,
wherein the monocarboxylic acid (A1) has a molecular weight of 180 or greater and 350 or less.

3. The flux according to Claim 1 or 2,
wherein a content of the solvent (S1) is 65% by mass or greater with respect to a total mass of the solvent (S).

4. The flux according to any one of Claims 1 to 3, further comprising:
an alkanolamine.

5. The flux according to any one of Claims 1 to 4,
wherein a content of the monocarboxylic acid (A1) is 0.5% by mass or greater and 20% by mass or less with respect to a total mass of the flux.

6. The flux according to any one of Claims 1 to 5,
wherein the monocarboxylic acid (A1) includes palmitic acid, and
a content of the palmitic acid is 60% by mass or greater with respect to a total mass of the monocarboxylic acid (A1).

7. The flux according to any one of Claims 1 to 6,
wherein a content of the rosin is 10% by mass or greater and 50% by mass or less with respect to a total mass of the flux.

8. A method for producing a bonded object in which a die and a lid are bonded to each other through a thermal interface material (TIM),
wherein the TIM is an indium sheet, and
the bonding is performed by a reflow method with the flux according to any one of Claims 1 to 7 being sandwiched between at least one of the TIM and the die or the TIM and the lid.

9. The method for producing a bonded object according to Claim 8,
wherein the bonding is performed by the reflow method at a temperature of lower than 200°C.
